# EUROPÄISCHE PATENTANMELDUNG

(11) **EP 3 012 621 A1**
(43) Veröffentlichungstag der Anmeldung: **27.04.2016**
(21) Anmeldenummer: 14003605.4
(22) Anmeldetag: 22.10.2014
(51) Int. Cl.: G01N 23/227, B81C 1/00, H01L 21/02

(54) **Verfahren zur Herstellung eines Bauteils**

(71) Anmelder: Bundesrepublik Deutschland, vertreten durch das Bundesministerium für Wirtschaft und Technologie, dieses vertreten durch den Präsidenten der, 38116 Braunschweig (DE)
(72) Erfinder: Bütefisch, Sebastian, 38229 Salzgitter (DE); Weimann, Thomas, 38159 Vechelde (DE); Danzebrink, Hans-Ulrich, 38124 Braunschweig (DE); Busch, Ingo, 38106 Braunschweig (DE)
(74) Vertreter: Friedrich, Andreas

(57) **Zusammenfassung**

Die Erfindung betrifft ein Verfahren zum Herstellen eines Bauteiles (16) mit einer Oberfläche (14), die eine vorbestimmte Oberflächenrauigkeit aufweist, wobei das Verfahren die folgenden Schritte aufweist:
a) Bereitstellen eines ersten Substrates (2) mit einer ersten Oberfläche (4), die die vorbestimmte Oberflächenrauigkeit aufweist,
b) Aufbringen wenigstens einer Materialschicht (8, 10) auf die erste Oberfläche (4) des ersten Substrates (2),
c) Entfernen des ersten Substrates (2).

## Beschreibung

Die Erfindung betrifft ein Verfahren zum Herstellen eines Bauteiles mit einer Oberfläche, die eine vorbestimmte Oberflächenrauigkeit aufweist.

Heute werden in vielen Bereichen der Technik kleine und kleinste Strukturen auf Oberflächen aufgebracht, wie dies beispielsweise bei der Prozessorherstellung geschieht. Insbesondere zur Qualitätskontrolle ist es wichtig, über Verfahren und Vorrichtungen zu verfügen, mit denen die aufgebrachten Strukturen begutachtet und auf Vollständigkeit und Fehlerlosigkeit überprüft werden können. Eines dieser dafür verwendeten Verfahren ist das "Imaging XPS"-Verfahren. Die Abkürzungen "XPS" steht dabei für X-ray Photoelectron Spectroscopy. Bei diesem Verfahren wird Röntgenstrahlung einer bekannten Wellenlänge auf die zu untersuchende Oberfläche geleitet. Dadurch werden Elektronen aus dem Material der Oberfläche herausgelöst, die als sogenannte Photoelektronen bezeichnet werden. Die Geschwindigkeit bzw. Energie dieser Elektronen hängt von der Elektronenstruktur und damit von der Art des Materials ab, aus dem sie herausgelöst wurden. Beim "Imaging XPS"-Verfahren werden die so herausgelösten Elektronen mit zweidimensionalen Detektoren analysiert, sodass die Oberfläche, die mit der Röntgenstrahlung bestrahlt wurde, abgebildet werden kann. Auf diese Weise ist es möglich, Unterschiede im Material der Oberfläche festzustellen und zweidimensional abzubilden. Alternativ oder zusätzlich dazu kann die Oberfläche auch über Rasterkraftmikroskope beispielsweise scannend beobachtet werden, um ein ortsaufgelöstes Bild der Materialverteilung zu erhalten.

Die jeweiligen Vorrichtungen zur Durchführung dieser Verfahren müssen ggf. in regelmäßigen Abständen kalibriert werden. Dazu sind Kalibriernormale nötig, die über eine vorgegebene und bekannte Verteilung bekannter Materialien an ihrer Oberfläche verfügen. Problematisch für diese Messverfahren ist jedoch, dass Topographien, also Erhebungen oder Vertiefungen, mit großen Gradienten, beispielsweise Stufen oder Spalten, des darzustellenden Materials zu Fehlmessungen führen. Um die laterale Ortsauflösung eines derartigen Instrumentes zur Durchführung eines der genannten Verfahren kalibrieren zu können, ist es daher nötig, ein Referenzmaterial oder Kalibriernormal herzustellen, das eine möglichst topographiefreie Oberfläche aufweist, um Feldverzerrungen an eventuellen Stufen oder Vertiefungen zu vermeiden. Diese würden zu Bereichen in der Abbildung führen, in denen die emitierten Elektronen einer fehlerhaften lateralen Zuordnung unterliegen, wodurch Messfehler entstünden.

Auch bei der Untersuchung mit Rasterkraftmikroskopen können topographiefreie Strukturen zur Kalibrierung verwendet werden. Bei einem Rasterkraftmikroskop wird die Kraft zwischen einer Mikroskopspitze und der Oberfläche des zu untersuchenden Materials aufgezeichnet. Diese hängt naturgemäß insbesondere vom Abstand der Spitze von der Materialoberfläche aber auch von der Materialkombination zwischen Spitze und Oberfläche ab. Unterschiedliche Materialkombinationen von Spitze und Oberfläche täuschen folglich aufgrund eines jeweils anderen Kraftabstandsverhaltens selbst bei absolut topographiefreien Oberflächen unterschiedlicher Materialien eine virtuelle Topographie vor. Mit Kalibriernormalen, die bekanntermaßen eine topographiefreie Oberfläche aufweisen, könnten diese Effekte untersucht werden.

Es ist versucht worden, derartige topographiefreie Referenzmaterialien, die auch in anderen Verfahren und zu anderen Zwecken verwendet werden können, mit sogenannten "Hetereo-Oberflächen" herzustellen. Unter "Hetero-Oberflächen" werden Oberflächen verstanden, die aus einer Mehrzahl unterschiedlicher Materialien bestehen. Dazu wird zunächst eine erste Schicht aus einem ersten Material auf ein Substrat aufgebracht, wobei diese erste Schicht strukturiert ist und insbesondere Lücken aufweist. Anschließend wird eine zweite Schicht aus einem zweiten Material auf diese erste Schicht aufgebracht, die anschließend so strukturiert wird, dass die zweite Schicht in den Bereichen, in denen sie auf der ersten Schicht aufliegt, entfernt wird. Dabei kommt es jedoch oftmals zu Verschmierungen der Materialgrenze, die eine Kalibrierung der Ortsauflösung von Vorrichtungen beispielsweise zur Durchführung des "Imaging XPS"-Verfahrens nicht mehr zulassen. Ein ähnliches Problem ergibt sich, wenn ein Schichtaufbau aus unterschiedlichen Schichten verschiedener Materialien in einer Richtung beispielsweise senkrecht zum Schichtaufbau geschnitten wird, um eine Hetero-Oberfläche zu erzeugen. Auch dabei kommt es zu Materialverschmierungen der unterschiedlichen Schichten und damit nicht zu einer sauberen Materialgrenze, wie sie für Kalibrierzwecke benötigt wird.

Alternativ dazu kann auch auf die bereits strukturierte erste Schicht eine ebenfalls strukturierte zweite Schicht aus dem zweiten Material aufgebracht werden, die als Negativ der ersten Schicht angesehen werden kann. Dort, wo die erste Schicht einen Materialauftrag aufweist, sind in der zweiten Schicht Lücken vorgesehen, während dort, wo die erste Schicht Lücken aufweist, in der zweiten Schicht Material aufgetragen wird. Dabei kann es jedoch beispielsweise zu unterschiedlich dicken Schichten oder zu einer Passee-Verschiebung der beiden Schichten zueinander kommen, was eine nicht perfekte Oberfläche zur Folge hätte.

Aus dem wissenschaftlichen Artikel "Template-Stripped, Ultraflat Gold Surfaces with Coplanar, Embedded Titanium Micropatterns", ACS Publications Langmuir 2013, 29, 9935 - 9943, ist es bekannt, eine aus zwei Metallen bestehende Oberfläche zu erzeugen, wobei die unterschiedlichen Materialien in einem Photolithographieprozess auf ein Substrat aufgebracht werden. Dabei ist es wichtig, dass die Materialschichten, bei denen es sich in dem Artikel um Gold und Titan handelt, nur eine relativ geringe Haftung mit dem Substrat eingehen, da das Substrat anschließend mechanisch entfernt. Sobald Materialschichten verwendet werden sollen, die eine zu große Haftung mit dem Substratmaterial des ersten Substrates aufweisen, muss dieses in einem aufwendigen Verfahrensschritt silanisiert werden, wodurch die Haftung reduziert wird. Dies hat einen notwendigen zusätzlichen Verfahrensschritt zu Folge, wodurch das Verfahren aufwendig und kostenintensiv wird. Zudem werden beim Silanisieren oftmals toxische Stoffe verwendet, so dass auch die Arbeitsschutzmaßnahmen verstärkt werden müssen. Hinzukommt, dass es beim mechanischen Entfernen des Substrates zu Beschädigungen der zu erzeugenden Oberfläche kommen kann, so dass oftmals ein relativ großer Anteil der zu erzeugenden Oberfläche nicht bestimmungsgemäß verwendet werden kann. Dies steht insbesondere einer Überführung des Verfahrens in einen industriell durchführbaren Prozess im Wege.

Der Erfindung liegt daher die Aufgabe zugrunde, ein Verfahren zum Herstellen eines Bauteils mit einer Oberfläche, die eine vorbestimmte Oberflächenrauigkeit aufweist, vorzuschlagen. Dabei soll die Oberfläche vorzugsweise vollständig, zumindest aber nahezu vollständig, topographiefrei ausgebildet werden.

Die Erfindung löst die gestellte Aufgabe durch ein neues Verfahren zum Herstellen eines Bauteils mit einer Oberfläche, die eine vorbestimmte Oberflächenrauigkeit aufweist, wobei das Verfahren die folgenden Schritte aufweist:
a) Bereitstellen eines ersten Substrates mit einer ersten Oberfläche, die die vorbestimmte Oberflächenrauigkeit aufweist,
b) Aufbringen wenigstens einer Materialschicht auf die erste Oberfläche des ersten Substrates,
c) Entfernen des ersten Substrates durch Ätzen.

Das erste Substrat besteht beispielsweise aus einem Siliziumwafer, dessen Oberfläche beispielsweise durch herkömmliche Poliervorgänge vollständig oder zumindest nahezu vollständig topographiefrei ausgebildet ist. Entsprechende Wafer werden beispielsweise bei der Chipherstellung in der Halbleiterindustrie verwendet und können mit einer nahezu perfekt topographiefreien ersten Oberfläche hergestellt werden.

Gemäß dem erfindungsgemäßen Verfahren wird auf diese erste Oberfläche wenigstens eine Materialschicht aufgebracht, bevor anschließend das erste Substrat entfernt wird. Dadurch wird die Fläche, mit der die aufgebrachte wenigstens eine Materialschicht auf der topographiefreien ersten Oberfläche des ersten Substrates auflag, zur freien Oberfläche, die die gewünschte Oberflächenrauigkeit bzw. Topographiefreiheit aufweist. Dabei ist von Vorteil, dass ein Beschichtungsprozess nicht mit besonderer Sorgfalt durchgeführt werden muss, da die Schichtdicke der aufgebrachten wenigstens einen Materialschicht keinen Einfluss auf die Qualität und Rauigkeit der Oberfläche des Bauteiles hat.

In einer bevorzugten Ausgestaltung des Verfahrens wird an der wenigstens einen Materialschicht ein zweites Substrat an einer dem ersten Substrat abgewandten Seite angeordnet, bevor das erste Substrat entfernt wird. Dies kann über unterschiedliche Verfahren geschehen, die aus dem Stand der Technik prinzipiell bekannt sind. Als vorteilhaft hat es sich herausgestellt, wenn das zweite Substrat an der wenigstens einen aufgebrachten Materialschicht eutektisch oder besonders bevorzugt anodisch gebondet wird. Dies hat eine besonders feste Verbindung und damit eine große Haltbarkeit zwischen der wenigstens einen aufgebrachten Materialschicht und dem daran angeordneten zweiten Substrat zur Folge. Durch die Verwendung eines zweiten Substrates bleibt die wenigstens eine aufgebrachte Materialschicht handhabbar, auch wenn sie beispielsweise durch Bedampfungs- oder andere Beschichtungsverfahren aufgebracht wird und nur eine sehr geringe Dicke, beispielsweise weniger Mikrometer oder gegebenenfalls sogar weniger Nanometer aufweist. Das zweite Substrat kann beispielsweise aus Siliziumdioxid (Pyrex) bestehen.

Erfindungsgemäß wird das erste Substrat durch einen Ätzprozess entfernt. Besteht das erste Substrat beispielsweise aus einem Siliziumwafer, kann beispielsweise Kalilauge verwendet werden, um den ersten Wafer zu entfernen. Vorteilhafterweise besteht ein gegebenenfalls vorhandenes zweites Substrat in diesem Fall aus beispielsweise Siliziumdioxid, auf das die Kalilauge keine ätzende Wirkung hat. In diesem Fall kann folglich der gesamte Schichtaufbau einfach in ein Bad von Kalilauge eingebracht werden, bis das erste Substrat vollständig entfernt wurde.

Vorzugsweise wird beim Ätzen ein Ätzmittel verwendet, gegen das das Material der wenigstens einen ersten Materialschicht beständig ist. Beständigkeit bedeutet in diesem Fall, dass das Material der wenigstens einen ersten Materialschicht von dem verwendeten Ätzmittel nicht oder nur in sehr geringem Maße angegriffen wird. Auf diese Weise ist es möglich, mit relativ wenig Überwachungsaufwand das erste Substrat durch den Ätzprozess zu entfernen, ohne die aufgebrachte wenigstens eine Materialschicht anzugreifen, was zu einer Beschädigung der zu erzeugenden glatten Oberfläche führen würde. Vorzugsweise ist zwischen der wenigstens einen aufgebrachten Materialschicht und im ersten Substrat eine ätzresistente Schicht angeordnet. Diese kann beispielsweise aus Siliziumdioxid oder Siliziumnitrid (Si3N4) bestehen und ist oftmals auf bekannte Wafer aus Silizium bereits aufgebracht. Eine derartige ätzresistente Schicht schützt die darauf aufgebrachte wenigstens eine Materialschicht, wenn das erste Substrat durch einen Ätzvorgang oder auf sonstige Weise entfernt wird. Bei diesem Vorgang ist es naturgemäß zu vermeiden, dass die wenigstens eine aufgebrachte Materialschicht ebenfalls in Mitleidenschaft gezogen wird, da in diesem Fall die gewünschte Topographiefreiheit der so entstandenen Oberfläche nicht mehr gewährleistet werden kann. Eine ggf. vorhandene ätzresistente Schicht schützt also die aufgebrachte Materialschicht während des Ätzvorganges, muss jedoch anschließend entfernt werden, bevor das so hergestellte Bauteil beispielsweise als Kalibriernormal für die genannten Oberflächen abbildenden Verfahren verwendet werden kann. Die ätzresistente Oberfläche kann beispielsweise über aus dem Stand der Technik bekannte Sputterverfahren oder in sonstiger Weise abgetragen werden. Der Abtragvorgang selbst kann in situ überwacht und beobachtet werden, sodass er abgebrochen und beendet werden kann, sobald die ätzresistente Schicht vollständig entfernt wurde. Dadurch wird gewährleistet, dass die wenigstens eine aufgebrachte Materialschicht nicht oder nur minimal beschädigt wird.

Vorzugsweise werden im Verfahrensschritt b) wenigstens zwei Materialschichten aus unterschiedlichen Materialien aufgebracht. Diese verfügen vorteilhafterweise über eine Struktur, sodass insbesondere in der ersten auf diese Weise aufgebrachten Schicht Löcher und Ausnehmungen vorhanden sind, die anschließend mit dem Material der wenigstens einen zweiten Schicht aufgefüllt werden können. Vorteilhafterweise wird auf diese Weise erreicht, dass wenigstens zwei unterschiedliche Materialien nach dem Aufbringen der wenigstens zwei Materialschichten in direktem Kontakt mit dem ersten Substrat oder der ätzresistenten Schicht stehen. Auf diese Weise werden nach dem Entfernen des ersten Substrates und gegebenenfalls der ätzresistenten Schicht topographiefreie Oberflächen hergestellt, die als Hetero-Oberflächen gekennzeichnet werden können und mehrere Materialien an der Oberfläche aufweisen. Durch die Strukturen der aufgebrachten Materialschichten können auch die räumlichen Verteilungen der unterschiedlichen Materialien bekannt und vorgegeben werden. Natürlich ist es auch möglich, mehr als zwei unterschiedliche Materialien in dieser Form aufzubringen, um beispielsweise für die Kalibrierung entsprechender Vorrichtungen mehrere unterschiedliche Materialübergänge auf der Oberfläche bereitstellen zu können. Auf diese Weise ist es möglich, nicht nur die laterale Auflösung der Vorrichtung zu kalibrieren und/oder zu überprüfen, sondern auch die Auflösung im Energiebereich der aufgefangenen Elektronen zu überprüfen und so die Auflösung bezüglich unterschiedlicher Materialien der Vorrichtung zu testen.

Die unterschiedlichen Materialien können beispielsweise Gold, Aluminium, Chrom oder andere Metalle sein, die in unterschiedlichsten Kombinationen und zweidimensionalen Mustern auf die erste Oberfläche des ersten Substrates oder die gegebenenfalls darauf positionierte ätzresistente Schicht aufgebracht werden.

Vorzugsweise besteht die letzte der so aufgebrachten Materialschichten aus einem Material, das sich mit einem Substratmaterial des zweiten Substrates, das vorzugsweise Siliziumdioxid ist, anodisch bonden lässt. Wie bereits dargelegt, kommt auf diese Weise eine besonders feste Verbindung zwischen den aufgebrachten Materialschichten und dem zweiten Substrat zustande.

In einer bevorzugten Ausgestaltung verfügt das zweite Substrat über wenigstens einen Durchbruch. Dies hat zur Folge, dass an dieser Stelle von beiden Seiten auf die wenigstens eine aufgebrachte Materialschicht zugegriffen werden kann und diese beispielsweise Experimenten oder Analyseverfahren unterzogen werden kann.

In einer bevorzugten Ausgestaltung ist an einer zweiten Oberfläche des zweiten Substrates wenigstens eine Zusatzmaterialschicht derart angeordnet, dass sie mit der wenigstens einen Materialschicht in Berührung kommt, wenn das zweite Substrat an der wenigstens einen Materialschicht angeordnet wird. Als besonders vorteilhaft hat sich dabei herausgestellt, dass die Zusatzmaterialschicht wenigstens einen Durchbruch aufweist, der mit wenigstens einem Durchbruch des zweiten Substrates zumindest teilweise in Überdeckung ist. Auf diese Weise kann eine freitragende Membran im Bereich der Durchbrüche erzeugt werden, die lediglich aus der wenigstens einen aufgebrachten Materialschicht besteht.

Die hier beschriebenen Verfahren weisen eine hohe Präzision in der Fertigung und eine nahezu perfekt topographiefreie Oberfläche des hergestellten Bauteils auf und sind zudem skalierbar, sodass auch eine Massenfertigung zumindest prinzipiell möglich ist. Insbesondere für den Fall, dass auf dem ersten Substrat eine ätzresistente Schicht aufgebracht wird, wird zudem die eigentliche topographiefreie Oberfläche, die in diesem Fall nach dem Entfernen des ersten Substrates noch vor der ätzresistenten Schicht abgedeckt ist, vor Umwelteinflüssen, wie beispielsweise einer mechanischen Beschädigung oder Verschmutzung durch Staub oder andere Materialien geschützt. Die ätzresistente Schicht kann in diesem Fall besonders vorzugsweise erst kurz vor der eigentlichen Verwendung des Bauteils beispielsweise als Kalibriernormal entfernt werden, sodass eine unverschmutzte und unbeschädigte Oberfläche verwendet werden kann.

Mit Hilfe der beigefügten Zeichnungen wird nachfolgend ein Ausführungsbeispiel der vorliegenden Erfindung näher erläutert. Es zeigt:
- Figuren 1a bis 1f: - ein Bauteil nach unterschiedlichen Verfahrensschritten eines Verfahrens gemäß einem ersten Ausführungsbeispiel der vorliegenden Erfindung,
- Figuren 2a bis 2e: - Bauteile nach unterschiedlichen Verfahrensschritten eines Verfahrens gemäß einem zweiten Ausführungsbeispiel der vorliegenden Erfindung und
- Figuren 3a bis 3d: - Bauteile nach unterschiedlichen Verfahrensschritten eines Verfahrens gemäß einem dritten Ausführungsbeispiel der vorliegenden Erfindung.

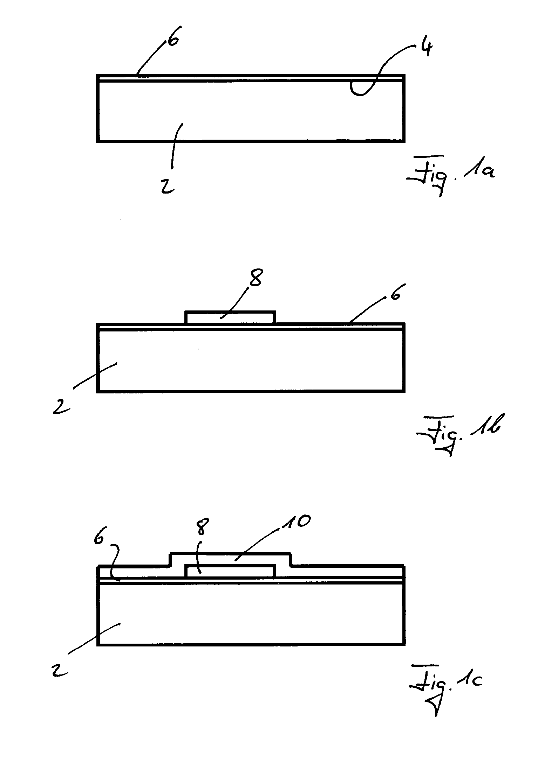

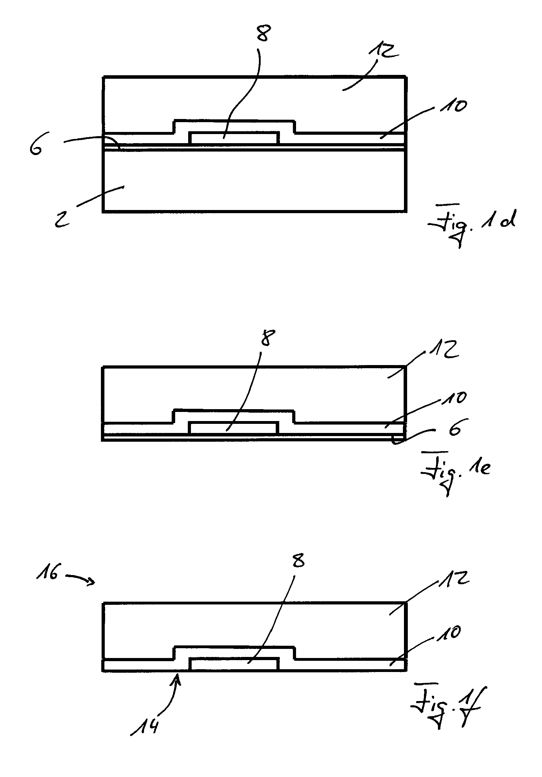

Figur 1 a zeigt ein erstes Substrat 2, das über eine erste Oberfläche 4 verfügt, beispielsweise durch Polieren oder Schleifen in einem vollständig topographiefreien oder zumindest nahezu vollständig topographiefreien Zustand versetzt wurde. Sie verfügt folglich über keine Erhebungen, Vertiefungen oder Stufen, sondern ist nahezu vollständig eben. An dieser ersten Oberfläche 4 des ersten Substrates 2 ist eine ätzresistente Schicht 6 angeordnet. Das erste Substrat 2 kann beispielsweise ein Siliziumwafer sein und die ätzresistente Schicht 6 kann beispielsweise aus Siliziumdioxid oder Siliziumnitrid bestehen.

Figur 1b zeigt den Schichtaufbau aus erstem Substrat 2 und ätzresistenter Schicht 6 nach dem Verfahrensschritt b. Es wurde eine erste Materialschicht 8 auf die Oberfläche der ätzresistenten Schicht aufgebracht. Man erkennt, dass die erste Materialschicht 8 nicht vollflächig auf die ätzresistente Schicht 6 aufgebracht wurde, sondern eine Struktur aufweist. Im gezeigten Ausführungsbeispiel ist sie nur in einem relativ kleinen Bereich der Oberfläche der ätzresistenten Schicht 6 aufgebracht worden.

Anschließend wird eine zweite Materialschicht 10 aufgebracht, die in Figur 1 c dargestellt ist. Die zweite Materialschicht 10 überdeckt die erste Materialschicht 8 vollständig und kommt somit in den Bereichen, in denen keine erste Materialschicht 8 auf die ätzresistente Schicht 6 aufgebracht wurde, mit dieser in Berührung. Natürlich ist es auch denkbar, mehr als zwei unterschiedliche Materialschichten aufzubringen, die jeweils strukturiert ausgebildet sind, sodass mehr als zwei unterschiedliche Materialien mit der ätzresistenten Schicht 6 in Kontakt kommen. Wird ein erstes Substrat 2 verwendet, auf dessen erster Oberfläche 4 sich keine ätzresistente Schicht 6 befindet, kommen die verschiedenen Materialschichten 8, 10 mit dem ersten Substrat 2 direkt in Kontakt.

Die erste Materialschicht kann beispielsweise aus Gold bestehen, während die zweite Materialschicht beispielsweise aus Aluminium hergestellt werden kann. Sie können durch aus dem Stand der Technik bekannte Beschichtungsverfahren, wie beispielsweise Bedampfungen oder andere Arten der Abscheidung, aufgebracht werden.

In Figur 1d ist zu erkennen, dass auf die zweite Materialschicht 10 ein zweites Substrat 12 aufgebracht wurde. Dies geschieht vorteilhafterweise durch anodisches oder eutektisches Bonden, kann jedoch auch durch Kleben oder andere Befestigungsmethoden erreicht werden. Das zweite Substrat 12 kann beispielsweise aus Siliziumdioxid bestehen und dient insbesondere dazu, die aufgebrachten Materialschichten 8, 10 auch nach einer Entfernung des ersten Substrates 2 weiterhin handhabbar zu halten.

In einem nächsten Verfahrensschritt, dessen Ergebnis in Figur 1e dargestellt ist, wird das erste Substrat 2 entfernt. Dies geschieht beispielsweise durch einen Ätzprozess, wobei die ätzresistente Schicht 6 so ausgebildet ist, dass sie durch diesen Ätzprozess nicht in Mitleidenschaft gezogen wird. Sie deckt folglich die Oberfläche, die aus der in Figur 1e unten dargestellten Seite der ersten Materialschicht 8 und der zweiten Materialschicht 10 gebildet wird, ab. Soll das Bauteil verwendet werden, wird in einem letzten Verfahrensschritt auch die ätzresistente Schicht 6 entfernt. Das Ergebnis ist in Figur 1f dargestellt. Es entsteht eine Oberfläche 14, die aus mehreren Materialien der unterschiedlichen Materialschichten 8, 10 besteht und aufgrund der Topographiefreiheit der ersten Oberfläche 4 des ersten Substrates 2 ebenfalls keinerlei Topographie aufweist. In Figur 1 ist somit ein Bauteil 16 dargestellt, das eine Oberfläche 14 aufweist, die die vorbestimmte Oberflächenrauigkeit, in diesem Fall also die Topographiefreiheit, aufweist.

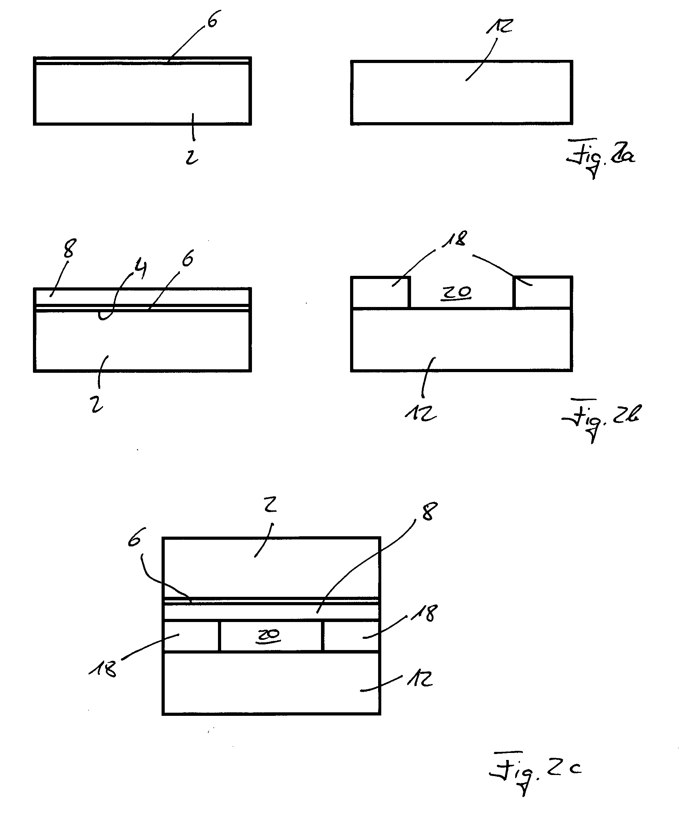

Die Figuren 2a bis 2e zeigen die Ergebnisse unterschiedlicher Verfahrensschritte eines Verfahrens gemäß einem zweiten Ausführungsbeispiel der vorliegenden Erfindung. Hier wird zunächst das erste Substrat 2 mit der ätzresistenten Schicht 6 und das zweite Substrat 12 bereitgestellt, wie es in Figur 2a dargestellt ist. Auf die ätzresistente Schicht 6, die sich wieder an der ersten Oberfläche 4 des ersten Substrates 2 befindet, wird wieder die erste Materialschicht 8 aufgebracht, die beispielsweise aus Gold, Chrom oder Aluminium bestehen kann. Ja nach Wahl des Materials für die erste Materialschicht 8 und erste Substrat 2 kann auf eine separate ätzresistente Schicht 6 verzichtet werden. Dies ist beispielsweise möglich, wenn das erste Substrat 2 Silizium ist, die erste Materialschicht 8 aus Gold besteht und als Ätzmittel Kalilauge KOH verwendet wird. Auf das zweite Substrat 12 wird in diesem Verfahren eine Zusatzmaterialschicht 18 aufgebracht, die im gezeigten Ausführungsbeispiel einen Durchbruch 20 aufweist, der in Figur 2b als Lücke dargestellt ist. Natürlich ist es auch hier möglich, mehr als nur die erste Materialschicht 8 auf die ätzresistente Schicht 6 aufzubringen und auf diese Weise beispielsweise Hetero-Oberflächen herzustellen. Im gezeigten Ausführungsbeispiel wird jedoch lediglich die erste Materialschicht 8 auf die ätzresistente Schicht 6 aufgebracht. Die so beschichteten Substrate 2, 12 werden nun aneinander angeordnet, wie es in Figur 2c dargestellt ist. Dabei kommt die erste Materialschicht 8 mit der Zusatzmaterialschicht 18 in Berührung, da der in Figur 2b links dargestellte Anteil um 180° gedreht auf dem rechts dargestellten Anteil befestigt wird. Der Durchbruch 20 wird auf diese Weise zu einem Hohlraum im Innern des Schichtaufbaus.

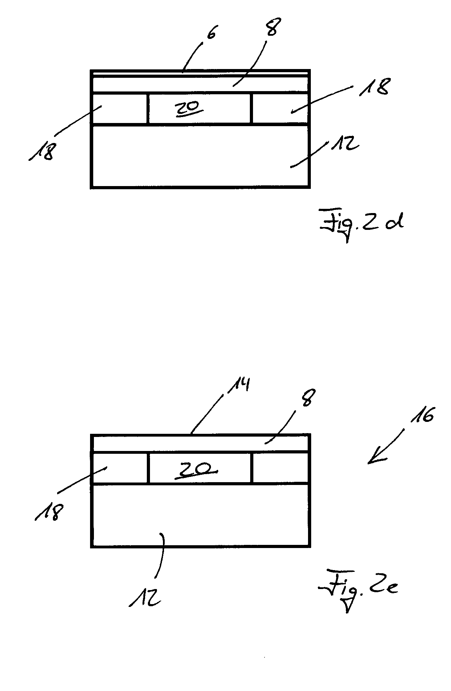

Anschließend wird das erste Substrat 2 entfernt, sodass die ätzresistente Schicht 6 als oberste Materialschicht die erste Materialschicht 8 abdeckt (siehe Figur 2d). Nachdem auch die ätzresistente Schicht 6 beispielsweise durch ein Sputterverfahren entfernt wurde, ist das in Figur 2e dargestellte Bauteil 16 fertig. Es verfügt über eine Oberfläche 14, die aufgrund der Topographiefreiheit der ersten Oberfläche 4 des ersten Substrates 2 ebenfalls keine Topographie aufweist. Unterhalb der ersten Materialschicht 8, die diese Oberfläche 14 bildet, befindet sich nun ein Hohlraum, der durch den Durchbruch 20 in der Zusatzmaterialschicht 18 gebildet wird. In einem weiteren Verfahrensschritt kann nun in das zweite Substrat 12 ein in den Figuren nicht dargestellter weiterer Durchbruch eingebracht werden, der mit dem Durchbruch 20 zumindest teilweise in Überdeckung ist. Auf diese Weise wird eine freitragende Membran aus der ersten Materialschicht 8 gebildet, die nun von beiden Seiten für Experimente oder Verfahren zugänglich ist. Natürlich können auch hier unterschiedliche Schichtaufbauten und Materialien verwendet werden und auch die Anzahl der aufgebrachten Materialschichten variiert werden.

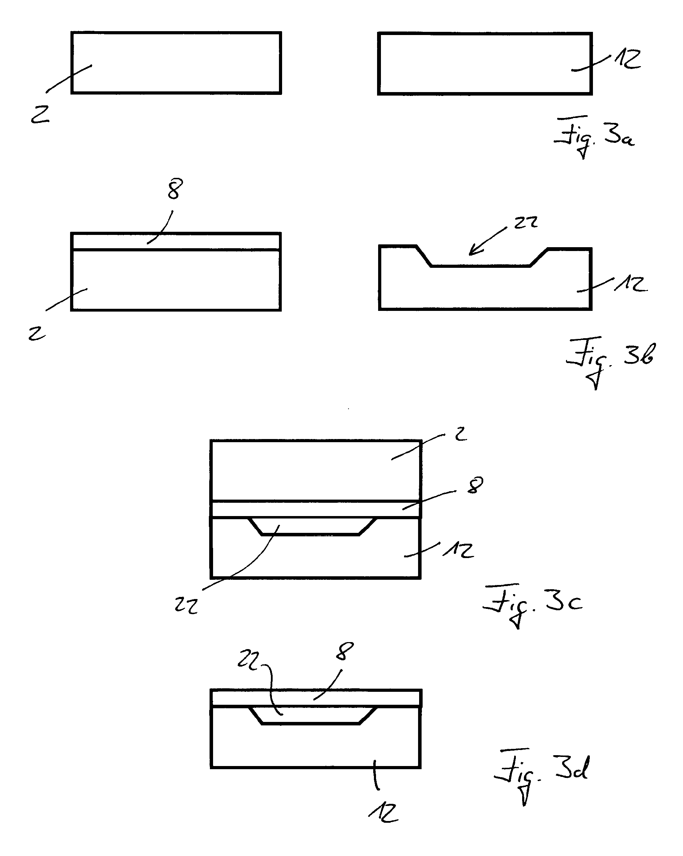

Figur 3a zeigt die Ausgangssituation für ein Verfahren gemäß einem weiteren Ausführungsbeispiel der vorliegenden Erfindung. Zunächst werden das erste Substrat 2 und das zweite Substrat 12 bereitgestellt.

Das erste Substrat 2 wird mit der ersten Materialschicht 8 beschichtet, während in das zweite Substrat 12 eine Struktur 22 eingebracht wird. Das Ergebnis dieser Bearbeitungsschritte ist in Figur 3b dargestellt.

Figur 3c zeigt den nächsten Verfahrensschritt. Wie bei dem in den Figuren 2a bis 2e beschriebenen Verfahren wird auch hier das zweite Substrat 12 mit der Struktur 22 auf der ersten Materialschicht 8 angeordnet. Dabei kann es beispielsweise zu einem eutektischen oder anoden Bonden kommen, wodurch eine besonders feste und haltbare Verbindung zwischen dem zweiten Substrat 12 und der ersten Materialschicht 8 kommt.

Anschließend wird das erste Substrat 2 durch einen Ätzprozess entfernt, so dass der in Figur 3d gezeigte Aufbau erreicht wird. Zum eutektischen Bonden kann die erste Materialschicht 8 beispielsweise aus Gold und das zweite Substrat 12 aus Silizium bestehen. Besteht das erste Substrat 2 beispielsweise aus einem Glas, kann als Ätzmittel Flusssäure verwendet werden. Dabei müsste das zweite Substrat beim Ätzen nicht gesondert vor dem Ätzmittel geschützt werden, da Silizium von Flusssäure nicht angegriffen wird.

### Bezugszeichenliste

- 2: erstes Substrat
- 4: erste Oberfläche
- 6: ätzresistente Schicht
- 8: erste Materialschicht
- 10: zweite Materialschicht
- 12: zweites Substrat
- 14: Oberfläche
- 16: Bauteil
- 18: Zusatzmaterialschicht
- 20: Durchbruch
- 22: Struktur

## Patentansprüche

1. Verfahren zum Herstellen eines Bauteiles (16) mit einer Oberfläche (14), die eine vorbestimmte Oberflächenrauigkeit aufweist, wobei das Verfahren die folgenden Schritte aufweist:
a) Bereitstellen eines ersten Substrates (2) mit einer ersten Oberfläche (4), die die vorbestimmte Oberflächenrauigkeit aufweist,
b) Aufbringen wenigstens einer Materialschicht (8, 10) auf die erste Oberfläche (4) des ersten Substrates (2),
c) Entfernen des ersten Substrates (2) durch Ätzen.

2. Verfahren nach Anspruch 1, **dadurch gekennzeichnet, dass** an der wenigstens einen Materialschicht (8, 10) ein zweites Substrat (12) an einer dem ersten Substrat (2) abgewandten Seite angeordnet wird, bevor das erste Substrat (2) entfernt wird.

3. Verfahren nach Anspruch 1 oder 2, **dadurch gekennzeichnet, dass** beim Ätzen ein Ätzmittel verwendet wird, gegen das das Material der ersten Materialschicht (8, 10) beständig ist.

4. Verfahren nach einem der vorstehenden Ansprüche, **dadurch gekennzeichnet, dass** zwischen der wenigstens einen Materialschicht (8, 10) und dem ersten Substrat (2) eine ätzresistente Schicht (6) angeordnet ist.

5. Verfahren nach einem der vorstehenden Ansprüche, **dadurch gekennzeichnet, dass** im Verfahrensschritt b) wenigstens zwei Materialschichten (8, 10) aus unterschiedlichen Materialien aufgebracht werden.

6. Verfahren nach Anspruch 5, **dadurch gekennzeichnet, dass** wenigstens zwei unterschiedliche Materialien nach dem Aufbringen der wenigstens zwei Materialschichten (8, 10) in direktem Kontakt mit dem ersten Substrat (2) oder der ätzresistenten Schicht (6) stehen.

7. Verfahren nach Anspruch 5 oder 6, **dadurch gekennzeichnet, dass** eine letzte der aufgebrachten Materialschichten (8, 10) aus einem Material besteht, das sich mit einem Substratmaterial des zweiten Substrates (12), das vorzugsweise Siliziumdioxid ist, anodisch bonden lässt.

8. Verfahren nach einem der Ansprüche 2 bis 7, **dadurch gekennzeichnet, dass** das zweite Substrat (12) wenigstens einen Durchbruch aufweist.

9. Verfahren nach einem der Ansprüche 2 bis 8, **dadurch gekennzeichnet, dass** an einer zweiten Oberfläche des zweiten Substrats (12) wenigstens eine Zusatzmaterialschicht (18) derart angeordnet ist, dass sie mit der wenigstens einen Materialschicht (8, 10) in Berührung kommt, wenn das zweite Substrat (12) an der wenigstens einen Materialschicht (8, 10) angeordnet wird.

10. Verfahren nach Anspruch 9, **dadurch gekennzeichnet, dass** die Zusatzmaterialschicht (18) wenigstens einen Durchbruch (20) aufweist, der mit dem Durchbruch des zweiten Substrates (12) zumindest teilweise in Überdeckung ist.
